# EUROPÄISCHE PATENTSCHRIFT

(11) **EP 0 341 534 B1**
(45) Veröffentlichungstag und Bekanntmachung des Hinweises auf die Patenterteilung: **13.07.1994**
(21) Anmeldenummer: 89107868.5
(22) Anmeldetag: 29.04.1989
(51) Int. Cl.: C08F 2/46, C09D 7/14, G03C 1/72

(54) **Fotoinitiator-Dispersionen**
Photoinitiator dispersions
Dispersions de photo-initiateurs

(30) Priorität: 07.05.1988 DE 3815622
(43) Veröffentlichungstag der Anmeldung: 15.11.1989
(73) Patentinhaber: CIBA-GEIGY AG, 4002 Basel (CH)
(72) Erfinder: Ohngemach, Jörg, Dr., D-6107 Reinheim (DE); Zeh, Heiko, D-6108 Weiterstadt (DE)

(56) Entgegenhaltungen:
- US-A- 4 874 827
- CHEMICAL ABSTRACTS, Band 75, Nr. 4, 26. Juli 1971, Seite 31, Zusammenfassung Nr. 21466v, Columbus, Ohio, US; & JP-A-71 06 422 (KUREHA CHEMICAL INDUSTRY CO., LTD)

## Beschreibung

Die Erfindung betrifft wäßrige Fotoinitiator-Dispersionen zur Einarbeitung in wäßrige Dispersionen strahlungshärtbarer Bindemittelsysteme.

Fotochemisch induzierte Polymerisationsreaktionen haben in der Technik große Bedeutung erlangt, insbesondere wenn es um eine schnelle Härtung von dünnen Schichten geht wie z.B. bei der Härtung von Lacküberzügen und Kunststoffbeschichtungen auf Papier, Holz, Metall und Kunststoff oder bei der Trocknung von Druckfarben. Dabei zeichnet sich die Strahlungshärtung in Gegenwart von Fotoinitiatoren gegenüber konventionellen Methoden zum Trocknen oder Härten von Beschichtungen durch Rohstoff- und Energieersparnis, geringe thermische Belastung des Untergrundes und insbesondere eine hohe Geschwindigkeit aus. Hierfür geeignete Fotoinitiatoren sind überwiegend Verbindungen vom Typ der aromatischen Ketone wie Benzophenone, Benzoinether, Benzilmonoketale, Dialkoxyacetophenone, Thioxanthone oder Hydroxyalkylphenone sowie von diesen Strukturtypen abgeleitete Derivate. Als besonders vorteilhaft haben sich Hydroxyalkylphenon-Fotoinitiatoren, wie sie in den Patentschriften DE-PS 27 22 264 und EP-PS 3002 beschrieben sind, erwiesen, vor allem aufgrund ihrer hohen Reaktivität aber auch wegen ihrer geringen Neigung, die gehärteten Schichten zu vergilben, sowie der vorzüglichen Dunkellagerstabilität der mit ihnen versetzten strahlungshärtbaren Systeme.

Als umweltfreundliche Beschichtungsmittel haben seit einiger Zeit wäßrige, von flüchtigen organischen Bestandteilen freie Systeme an Interesse gewonnen, insbesondere weil damit eine Verschmutzung der Umwelt durch organische Lösungmittel und Monomere vermieden oder zumindest verringert, die Feuergefährlichkeit im Umgang mit lösungsmittelhaltigen Beschichtungs-, Imprägnierungs- und Klebstoffstoffzubereitungen gemindert sowie die hohen Kosten für organische Lösungsmittel eingespart werden können.

Strahlungshärtbare wäßrige Systeme, vornehmlich in Form wäßriger Dispersionen, vereinen demnach die Vorteile der Strahlungshärtung mit dem Vorzug der Lösungsmittelfreiheit im wäßrigen System.

Wäßrige Systeme auf Basis strahlungshärtbarer Bindemittel stellen besondere Anforderungen an den verwendeten Fotoinitiator, vor allem an die Löslichkeit bzw. Einarbeitbarkeit sowie die Stabilität des Initiators in dem wäßrigen System, an die Dunkellagerstabilität des mit dem Initiator versetzten wäßrigen Systems, das Verhalten des Initiators bei der Entfernung des Wassers sowie vor allem an seine Reaktivität, die die Geschwindigkeit der Härtung bestimmt. Die meisten Fotoinitiatoren der vorgenannten Typen werden zwar überwiegend in nichtwäßrigen strahlungshärtbaren Systemen eingesetzt, zeigen sich im allgemeinen aber auch für wäßrige Systeme geeignet. Die in den Offenlegungsschriften DE-OS 32 03 096 und DE-OS 35 12 179 beschriebenen speziellen Hydroxyalkylphenonderivate eignen sich in besonderem Maße für wäßrige Systeme, insbesondere für wäßrige Dispersionen strahlungshärtbarer Bindemittelsysteme, aufgrund ihrer geringen Wasserdampfflüchtigkeit bzw. ihren besonders günstigen Lösungs- bzw. Mischungseigenschaften mit dem System.

Die Anwendung von Fotoinitiatoren in wäßrigen Dispersionen strahlungshärtbarer Bindemittelsysteme ist jedoch noch verbesserungswürdig, insbesondere in Richtung auf eine noch homogenere Einarbeitung der Fotoinitiatoren in das System, auf die Lagerstabilität der mit Fotoinitiatoren versetzten Systeme sowie auf die Reaktivität, also das erzielbare Härtungsergebnis.

Bislang wurden bei der Anwendung die Fotoinitiatoren in reiner unveränderter Substanz den wäßrigen Bindemitteldispersionen kurz vor deren Verarbeitung zugegeben und in diesen durch Rühren oder auch Eindispergieren möglichst gleichmäßig verteilt.

Zufällig und völlig überraschend wurde nun gefunden, daß mit Fotoinitiatoren versetzte strahlungshärtbare wäßrige Bindemitteldispersionen erheblich bessere Härtungs-und/oder Lagereigenschaften aufweisen, wenn in diese die Fotoinitiatoren ihrerseits in Form wäßriger Dispersionen eingearbeitet werden. Die erfindungsgemäßen wäßrigen Fotoinitiator-Dispersionen sind hierbei so zusammengesetzt, daß sie jeweils etwa 10-50 Gew. %, bezogen auf die Gesamtmenge, an Fotoinitiator und etwa 5-50 Gew. %, bezogen auf den Gehalt an Fotoinitiator, an nichtionogenen Tensiden mit einem resultierenden HLB-(Hydrophilie-Lipophilie-Balance)-Wert zwischen 8 und 18 enthalten.

Gegenstand der Erfindung sind daher wäßrige Fotoinitiator-Dispersionen zur Einarbeitung in wäßrige Dispersionen strahlungshärtbarer Bindemittelsysteme, enthaltend 10-50 Gew. %, bezogen auf die Gesamtmenge, an Fotoinitiator, und 5-50 Gew. %, bezogen auf den Gehalt an Fotoinitiator, an nichtionogenen Tensiden mit einem resultierenden HLB-Wert zwischen 8 und 18.

Gegenstand der Erfindung ist außerdem ein Verfahren zur Herstellung von Fotoinitiatoren enthaltenden wäßrigen Dispersionen strahlungshärtbarer Bindemittelsysteme, wobei die Fotoinitiatoren in Form einer wäßrigen Dispersion eingearbeitet werden.

Für die erfindungsgemäßen wäßrigen Fotoinitiator-Dispersionen sind im Prinzip alle in der Technik der Strahlungshärtung bekannten und üblichen Fotoinitiatoren vom Typ der aromatischen Ketone geeignet. Dabei spielt es keine Rolle ob sie bei Raumtemperatur im festen oder flüssigen Aggregatzustand vorliegen. Dem einschlägigen Fachmann sind eine Vielzahl verschiedener Fotoinitiatoren aus den Gruppen der Benzophenone, Benzoylether, Benzilmonoketale, Dialkoxyacetophenone, Thioxanthone und Hydroxyalkylphenone bekannt; er kann problemlos aus diesen Gruppen seinen Bedürfnissen und den spezifischen Anforderungen der jeweiligen strahlungshärtbaren Systeme und ihrer Anwendung entsprechend auswählen. Zahlreiche Fotoinitiatoren dieser Verbindungstypen sind kommerziell verfügbar. Als typische Vertreter seien beispielhaft genannt Benzophenon, Benzildimethylketal, Benzoinmethylether, Benzoinisopropylether, Diethoxyacetophenon, Dibutoxyacetophenon, Methylphenylglykoxylat, 2-Chlorthioxanthon, 2-Ethylthioxanthon, 2-Isopropylthioxanthon, 2,4-Diethylthioxanthon, Phenyl-2-hydroxy-2-propylketon, (4-Isopropylphenyl)-2-hydroxy-2-propylketon, (4-n-Dodecylphenyl)-2-hydroxy-2-propylketon, [4-(2-Hydroxyethoxy)-phenyl]-2-hydroxy-2-propylketon, [4-(2-Acryloyloxyethoxy)-phenyl]-2-hydroxy-2-propylketon, 1-Benzoylcyclohexanol. Aufgrund ihrer bekanntermaßen in vielerlei Hinsicht vorteilhaften Eigenschaften sind Fotoinitiatoren vom Typ der Hydroxyalkylphenone besonders bevorzugt, insbesondere Phenyl-2-hydroxy-2-propylketon, 1-Benzoylcyclohexanol, [4-(2-Hydroxyethoxy)-phenyl]-2-hydroxy-2-propylketon. In den erfindungsgemäßen wäßrigen Fotoinitiator-Dispersionen können die Fotoinitiatoren einzeln oder als Gemische von 2 oder mehreren Fotoinitiatoren vorliegen. Weiterhin können auch Gemische von 1 oder mehreren Fotoinitiatoren mit die Fotoreaktivität und/oder die spektrale Empfindlichkeit steigenden Co-Initiatoren, Sensibilisatoren und Beschleunigern wie insbesondere organischen Aminoverbindungen zu entsprechenden Dispersionen verarbeitet werden. Typische Gemische von Fotoinitiatoren miteinander bzw. mit Co-Initiatoren und Sensibilisatoren sind aus dem Stand der Technik, insbesondere aus den bereits zitierten Schriften zu entnehmen. Beispiele hierfür sind etwa die kommerziell erhältlichen Gemische aus Phenyl-2-hydroxy-2-propylketon und Isopropylthioxanthon sowie aus Phenyl-2-hydroxy-2-propylketon, Isopropylthioxanthon und 2-Dimethylaminoethylbenzoat.

Die erfindungsgemäßen wäßrigen Fotoinitiator-Dispersionen enthalten 10-50 Gew. %, vorzugsweise 25-45 Gew. % an solchen Fotoinitiatoren bzw. Fotoinitiatorgemischen.

Um mit den Fotoinitiatoren und Wasser stabile und homogene Dispersionen herzustellen sind Dispergierhilfsmittel erforderlich. Es hat sich herausgestellt, daß hierfür praktisch nur nichtionogene Tenside geeignet sind, wobei durch Mischung von normalerweise 2 oder gegebenenfalls auch mehr Tensiden ein resultierender HLB-Wert zwischen 8 und 18 eingestellt werden muß. Vorzugsweise liegt der resultierende HLB-Wert des Tensid-Gemisches zwischen 10 und 16.

Nichtionogene Tenside der verschiedensten Typen und ihre das Dispergierverhalten charakterisierenden HLB-Werte sind dem Fachmann in großer Vielfalt aus dem einschlägigen Stand der Technik bekannt und stehen ihm zur Verfügung.

Bei der Kombination von Tensiden mit unterschiedlichem HLB-Wert ergibt sich der resultierende HLB-Wert des Gemisches additiv im Verhältnis der eingesetzten Gewichtsmengen der verschiedenen Tenside. Den Erfordernissen entsprechende Tensidkombinationen können also problemlos ausgewählt und ihre spezifische Eignung für den jeweiligen Fotoinitiator durch einfaches Ausprobieren ermittelt werden.

Als besonders geeignet haben sich Gemische aus Polyglycoletherderivaten von Fettalkoholen und Fettalkohol-Fettsäureestern erwiesen. Von den zugrundeliegenden Fettalkoholen sind hier insbesondere Stearylalkohol und Cetylalkohol, von den Fettsäureestern Fettalkoholstearate und Fettalkoholpalmitate hervorzuheben. Gängige Beispiele derartiger nichtionogene Tenside sind etwa Polyoxyethylenstearylalkohole wie Polyoxyethylen-(100)-stearylalkohol mit einem HLB-Wert von 19 und Polyoxyethylenstearylstearate wie Polyoxyethylen-(5)-stearylstearat mit einem HLB-Wert von 7,5. Diese und ähnliche gleichermaßen geeignete Tenside sind dem Fachmann bekannt und aus industrieller Produktion erhältlich.

In den erfindungsgemäßen wäßrigen Fotoinitiator-Dispersionen haben die Tenside bzw. Tensid-Gemische normalerweise einen Anteil von 5-50 Gew. %, insbesondere von 10-30 Gew. %, bezogen auf den Gehalt an Fotoinitiator.

Die Herstellung der erfindungsgemäßen wäßrigen Fotoinitiator-Dispersionen erfolgt in für wäßrige Dispersionen an sich bekannter Weise mit hierfür üblichen Hilfsmitteln. Sie ist bei Einhaltung der angegebenen Rahmenbedingungen bezüglich der Menge an Fotoinitiator, Tensid und HLB-Wert im wesentlich unkritisch. Die für den Einzelfall optimalen Zusammensetzungen und Verfahrensweisen können mit Routineerfahrung durch einfaches Ausprobieren problemlos ermittelt werden.

Als vorteilhaft hat es sich erwiesen zunächst die organischen Bestandteile, also Fotoinitiator(en) und Tenside homogen zu vermischen. Hierbei kann im Einzelfall eine Temperierung auf etwa 60-100 °C hilfreich sein. Danach wird dann das Wasser in der vorgesehen Menge, vorzugsweise voll entsalzt und bei gleicher Temperatur, unter intensiver Vermischungen mit üblichen Rühr- bzw. Homogenisiereinrichtungen zugegeben und solange intensiv vermischt bis eine homogene stabile Dispersion erhalten wird. Gegebenenfalls können auch noch weitere übliche Dispergierhilfsmittel zugesetzt werden, wie insbesondere Verdickungsmittel auf Basis wasserlöslicher, hochmolekularer organischer Verbindungen, beispielsweise Polyvinylalkohole, Polyvinylpyrrolidon oder Celluloseether.

Die erhaltenen wäßrigen Fotoinitiator-Dispersionen sind bei lichtgeschützter Aufbewahrung unter üblichen Lagerbedingungen ausreichend lange stabil. Sie überdauern auch mehrfachen klimatischen Temperaturwechsel, etwa im Bereich von ca. -10 bis +20 °C. Im Falle möglicher vorzeitiger Entmischung ist eine Rehomogenisierung unproblematisch.

Die erfindungsgemäßen wäßrigen Fotoinitiator-Dispersionen können sehr vorteilhaft zur Initiierung von wäßrigen Dispersionen strahlungshärtbarer Bindemittelsysteme eingesetzt werden. Ein besonderer Vorteil hierbei ist, daß sich die Fotoinitiatoren in Form der erfindungsgemäßen wäßrigen Dispersionen schneller und besser in diese Systeme einarbeiten lassen, als wenn sie für sich alleine eindispergiert werden. Als völlig unerwartet stellte sich hierbei heraus, daß wäßrige Dispersionen strahlungshärtbarer Bindemittelsysteme, in die die entsprechenden Fotoinitiatoren in Form einer wäßrigen Dispersion eingearbeitet wurden, eine bessere Lagerstabilität, insbesondere hinsichtlich Gelierung durch vorzeitige, nichtstrahlungsinduzierte Vernetzung aufweisen, und daß mit Hilfe solcher Systeme hergestellte Beschichtungen ein besseres Härtungsergebnis zeigen. Das bessere Härtungsergebnis zeigt sich etwa in einer kürzeren Bestrahlungsdauer zur Erzielung oberflächentrockener oder vollausgehärteter Beschichtungen und/oder in der Realisierung höherer Schichthärten unter gegebenen Prozeßbedingungen. Die Beschichtungen können somit schneller bzw. mit geringerem Energieaufwand, d.h. also wirtschaftlicher, und/oder qualitativ besser gehärtet werden.

Die gefundenen besseren Härtungsergebnisse sind insbesondere auch deswegen erstaunlich, weil im Normalfall bei der Beschichtung mit wäßrigen Bindemitteldispersionen vor der Strahlungshärtung das enthaltene Wasser durch Trocknung bei erhöhter Temperatur entfernt wird, wonach das initiatorhaltige, zu härtende Schichtmaterial nicht mehr in Form einer wäßrigen Dispersion vorliegt. Eine wissenschaftlich fundierte Erklärung der positiven Effekte, wenn Fotoinitiatoren statt für sich alleine in Form einer wäßrigen Dispersion in strahlungshärtbare Bindemitteldispersionen eingearbeitet werden, liegt noch nicht vor. Sie könnte aber in einer feineren und homogeneren Verteilung des Fotoinitiators im System und einer möglicherweise damit einhergehenden größeren "Nähe" des Fotoinitiators zu den strahlungsreaktiven Bestandteilen gesehen werden.

Die Herstellung fotoinitiierter wäßriger Dispersionen strahlungshärtbarer Bindemittelsysteme erfolgt erfindungsgemäß durch gleichmäßiges Einarbeiten der Fotoinitiator-Dispersion in die Bindemitteldispersion mit Hilfe üblicher Rühr- bzw. Homogenisierapparaturen. Mengenmäßig werden die erfindungsgemäßen wäßrigen Fotoinitiator-Dispersionen im Prinzip so eingesetzt, daß im strahlungshärtbaren System der Fotoinitiator in vergleichbarer Konzentration vorliegt wie bei konventioneller Anwendung. Fotoinitiatoren werden in der Regel in Mengen von 0,1-20 Gew. %, vorzugsweise 0,5-10 Gew. %, bezogen auf die polymerisierbaren Anteile, eingesetzt. Je nach Gehalt an Fotoinitiator sind daher entsprechende Mengen an Fotoinitiator-Dispersion zu wählen. Aufgrund der besseren Härtungseigenschaften der Fotoinitiatoren in Form wäßriger Dispersionen kann aber auch die Aufwandmenge entsprechend reduziert werden, wodurch die Wirtschaftlichkeit durch geringeren Initiatorverbrauch erhöht und im Einzelfall mögliche negative Einflüsse durch geringeren Restgehalt an Initiator oder seine Fotolyseprodukte in der gehärteten Schicht reduziert werden können.

Unter wäßrigen Dispersionen strahlungshärtbarer Bindemittelsysteme, die im übrigen in vielen Variation industriell hergestellt werden, werden Dispersionen von durch Fotopolymerisation bzw. Fotovernetzung härtbaren Komponenten mit Wasser verstanden, wobei diese auch noch weitere in dieser Technologie übliche Hilfs- und Zusatzstoffe enthalten können. Der strahlungshärtbare Anteil kann aus Ein- oder Mehrkomponentensystemen auf Basis von durch freie Radikale polymerisierbaren mono- oder polyfunktionellen ethylenisch ungesättigten Monomeren, Oligomeren, Prepolymeren oder Polymeren bestehen. Ihr Anteil in den Bindemitteldispersionen liegt in der Regel zwischen 20 und 95 Gew. %, vorzugsweise 40 bis 70 Gew. %, wobei sich der prozentuale Wasseranteil zu 100 addiert und Hilfs- und Zusatzstoffe je nach Bedarf und Verwendungszweck in unterschiedlichen Mengen noch hinzukommen können. Überwiegend basieren strahlungshärtbare Bindemitteldispersionen auf ungesättigten Oligomeren und Präpolymeren wie ungesättigte Polyester-, Polyacrylat-, Epoxid-, Polyurethan- und Polyamidharze, insbesondere acrylierte Polyester, acrylierte Acryl- und Epoxidharze, acrylierte Polyurethane und Polyamide. Gelegentlich enthalten sie auch Anteile von ungesättigten Monomeren, vorzugsweise vom Acryl- und Vinyltyp, insbesondere Acrylester von Mono-, Di- oder Polyalkoholen, wie beispielsweise Ethylenglycoldiacrylat, 1,6-Hexandioldiacrylat, Trimethylolpropandiacrylat und Pentaerythrittriacrylat.

Je nach Verwendungszweck können den strahlungshärtbaren Bindemitteldispersionen in der Lack- bzw. Beschichtungstechnologie übliche Farbstoffe, Pigmente und/oder Füllstoffe sowie Verlaufsmittel, Gleitmittel, Netzmittel, Verdickungsmittel sowie Mattierungsmittel zugesetzt sein.

Die Applikation strahlungshärtbarer Bindemitteldispersionen erfolgt nach üblichen Beschichtungsmethoden auf den hierfür vorgesehenen Substraten wie Metall, Holz, Papier, Glas, Keramik. Die Strahlungshärtung der Beschichtungen erfolgt normalerweise nach vollständiger Entfernung des Wassers aus der Schicht. Dies wird erreicht durch Abdunsten, vorzugsweise gefördert durch kurzes Erhitzen auf Temperaturen bis etwa 100 °C oder durch kurzzeitige IR-Bestrahlung. Bei porösen Substraten sind meist nur sehr kurze Vorheizzeiten erforderlich, da die Hauptmenge des Wassers vom Untergrund aufgenommen wird. Gelegentlich wird auch auf ein Vorheizen bzw. auf eine Wasserentfernung verzichtet. Die anschließende Fotopolymerisation erfolgt durch Bestrahlen mit Licht oder UV-Strahlung des Wellenlängenbereiches von 250-500 nm, vorzugsweise von 300-400 nm. Als Strahlungsquellen können Sonnenlicht oder künstliche Strahler verwendet werden. Üblich sind beispielsweise Quecksilberdampf-Hochdruck-, -Mitteldruck- oder -Niederdrucklampen sowie Xenon- und Wolframlampen.

### Beispiele

A. Verwendete Materialien
Fotoinitiatoren:
(a) Phenyl-2-hydroxy-2-propylketon (Darocur 1173, Fa. E. Merck)
(b) (4-Isopropylphenyl)-2-hydroxy-2-propylketon (Darocur 1116, Fa. E. Merck)
(c) Gemisch aus (a) und 2-Isopropylthioxanthon/9:1 (Darocur 1664, Fa. E. Merck)
(d) Gemisch aus (a), 2-Isoproylthioxanthon and 2-Dimethylaminoethylbenzoat/3:2:2 (Darocur 2273, Fa. E. Merck)
(e) Gemisch aus (a) und [4-(2-Hydroxyethoxy)-phenyl]-2-hydroxy-2-propylketon (Darocur 2959, Fa. E. Merck)/7:3
(f) Gemisch aus 1-Benzoylcyclohexanol (Irgacure 184, Fa. Ciba Geigy) und (a)/8:2
(g) 2,2-Diethoxyacetophenon (DEAP, Fa. Upjohn)
(h) 2,2-Dibutoxyacetophenon (Uvatone 8301, Fa. Upjohn)
(i) Methylphenylglykoxylat (Vicure 55, Fa. Stauffer Chemicals)
Tenside:
(I) Polyoxyethylen-(100)-stearylalkohol (Brij 700, Fa. ICI Atlas Chemie)
   HLB-Wert: 19,0
(II) Polyoxyethylen(2)-stearylalkohol (Brij 72, Fa. ICI Atlas Chemie)
   HLB-Wert: 5,0
(III) Polyoxyethylen-(5)-stearylstearat (Arlatone 985, Fa. ICI Atlas Chemie)
   HLB-Wert: 7,5
Bindemittelsysteme:
(A) wäßrige Dispersion eines Polyesteracrylates (Laromer PE 55 W, Fa. BASF)
(B) wäßrige Dispersion eines Urethanacrylates (Hüls RC 1622, Fa. Chemische Werke Hüls)
(C) wäßrige Dispersion eines Nitrocellulose-Polyesteracrylates (Waloran NH 6002, Fa. Wolff Walsrode )

B. Herstellung von Fotoinitatordispersionen
Fotoinitiatoren und Tenside wurden in den in der nachfolgenden Tabelle angegebenen Mengenverhältnissen bei ca. 80 °C gemischt. Dann wurde unter intensivem Rühren die auf 100 Gew. % benötigte, ebenfalls auf ca. 80 °C temperierte Menge vollentsalztes Wasser langsam kontinuierlich zugegeben. Es wurde noch etwa 10 Minuten bei dieser Temperatur und dann bis Erreichen der Raumtemperatur homogenisiert. Nach weiteren 3 Stunden langsamen Rühren waren die Fotoinitiatordispersionen gebrauchsfertig bzw. konnten in lichtgeschützte Gefäße abgefüllt werden.

| Beispiel Nr. | Fotoinitiator/Gew. % | Tenside/Gew. % | | Resultierender HLB-Wert |
|---|---|---|---|---|
| 1 | (a)/40 | (I)/4.8 | (II)/3.2 | 13.4 |
| 2 | (a)/40 | (I)/4.5 | (III)/5.5 | 12.5 |
| 3 | (b)/40 | (I)/4.3 | (III)/2.7 | 14.5 |
| 4 | (c)/40 | (I)/6.7 | (III)/4.3 | 14.5 |
| 5 | (d)/40 | (I)/7.0 | (III)/2.0 | 16.5 |
| 6 | (e)/40 | (I)/7.3 | (III)/4.7 | 14.5 |
| 7 | (f)/40 | (I)/8.9 | (III)/3.1 | 16.0 |
| 8 | (g)/40 | (I)/3.6 | (III)/2.4 | 14.5 |
| 9 | (h)/40 | (I)/2.4 | (III)/3.6 | 12.0 |
| 10 | (i)/40 | (I)/3.5 | (III)/5.5 | 11.0 |

C. Herstellung von fotoinitiatorhaltigen Bindemitteldispersionen und Vergleichsversuche
Für die nachfolgenden Versuche wurden durch 10 Minuten schnelles Verrühren in den Mengenverhältnissen gemäß nachfolgender Tabelle von Bindemittelsystemen (A), (B) und (C), ausgewählten Fotoinitiatordispersionen aus den Beispielen 1-10 und vollentsalztem Wasser die Systeme A1... A10, B1.. B10, C1... C10 und Vergleichssysteme A(a).... A(i), B(a)... B(i), C(a)... C(i), denen der jeweilige Fotoinitiator für sich alleine in der entsprechenden Menge zugegeben wurde, hergestellt.
Die fotoinitiatorhaltigen Bindemittelsysteme wurden nach der Herstellung noch ca. 12 Stunden bei Raumtemperatur gelagert.

| Gew.% | Bindemittelsystem | Initiator | Wasser |
|---|---|---|---|
| A1 ... A10 | 90 | 3,8 | 6,2 |
| A(a) ... A(i) | 90 | 1,5 | 8,5 |
| B1 ... B10 | 90 | 2,5 | 7,5 |
| B(a) ... B(i) | 90 | 1,0 | 9,0 |
| C1 ... C10 | 90 | 7,5 | 2,5 |
| C(a) ... C(i) | 90 | 3,0 | 7,0 |

Systeme und Vergleichssysteme enthalten die gleiche effektive Menge an jeweiligem Initiator.
Vergleichsversuchsreihe 1: Lagerstabilität
Systeme und Vergleichssysteme wurden bei 60 °C gelagert und die Zeit ermittelt, bis erste Veränderungen (Gelieren) erkennbar wurden.

| | | | | | | |
|---|---|---|---|---|---|---|
| System | A1 | A2 | A3 | A4 | A6 | A7 |
| Vergleichssystem | A(a) | A(a) | A(b) | A(c) | A(e) | A(f) |
| Lagerzeit in Wochen | 3 | 3 | 3 | 3 | 3 | 2 |
| | 2 | 2 | 2 | 1 | 2 | 1 |

| | | | | | | | | |
|---|---|---|---|---|---|---|---|---|
| System | C2 | C3 | C4 | C5 | C6 | C7 | C8 | C9 |
| Vergleichssystem | C(a) | C(b) | C(c) | C(d) | C(e) | C(f) | C(g) | C(h) |
| Lagerzeit in Wochen | 2 | 3 | 3 | 3 | 3 | 3 | 3 | 3 |
| | 1 | 2 | 2 | 1 | 1 | 1 | 2 | 1 |

Es zeigt sich, daß die Systeme, in die die Fotoinitiatoren in Form der erfindungsgemäßen wäßrigen Dispersionen eingearbeitet worden sind, eine erheblich verbesserte Lagerstabilität besitzen.
Vergleichsversuchsreihe 2: Oberflächentrocknung
Die gebrauchsfertigen wäßrigen Bindemittelsysteme wurden mit einem 150 »m-Filmziehrahmen auf Glasplatten (10 x 10 cm) appliziert. Zur Entfernung des Wassers aus den Schichten wurden die beschichteten Glasplatten dann in einem Trockenschrank 10 Minuten bei 80 °C gelagert.
Die UV-Härtung erfolgte dann, indem die beschichteten Platten auf einem Transportband variabler Geschwindigkeit unter Hg-Mitteldrucklampen (Lampenleistung 1 x 80 W/cm für Systeme (A) und (B), 2 x 80 W/cm für Systeme (C); Lampenabstand 6 cm) vorbeigeführt wurden. Für die Systeme und Vergleichssysteme wurden die jeweiligen Maximalgeschwindigkeiten ermittelt, bei denen noch trockene Oberflächen erhalten wurden.

| | | | | | | | | |
|---|---|---|---|---|---|---|---|---|
| System | A1 | A2 | A3 | A4 | A7 | A8 | A9 | A10 |
| Vergleichssystem | A(a) | A(a) | A(b) | A(c) | A(f) | A(g) | A(h) | A(i) |
| Bandgeschwindigkeit in m/min | 25 | 35 | 22,5 | 22,5 | 35 | 17,5 | 12,5 | 27,5 |
| | 15 | 17 | 12,5 | 18 | 22,5 | 12,5 | 7,5 | 17,5 |

| | | | | |
|---|---|---|---|---|
| System | B2 | B4 | B5 | B8 |
| Vergleichssystem | B(a) | B(c) | B(d) | B(g) |
| Bandgeschwindigkeit in m/min | 35 | 27 | 18 | 25 |
| | 17 | 25 | 15 | 20 |

| | | | | | | | |
|---|---|---|---|---|---|---|---|
| System | C2 | C4 | C5 | C6 | C7 | C9 | C10 |
| Vergleichssystem | C(a) | C(c) | C(d) | C(e) | C(f) | C(h) | C(i) |
| Bandgeschwindigkeit in m/min | 22,5 | 35 | 25 | 22,5 | 22,5 | 12,5 | 22,5 |
| | 17 | 25 | 22,5 | 17,5 | 17,5 | 10 | 15 |

Die Systeme, in die die Fotoinitiatoren in Form der erfindungsgemäßen wäßrigen Dispersionen eingearbeitet worden sind, lassen sich bei deutlich höherer Bandgeschwindigkeit oberflächentrocken härten.
Vergleichsversuch 3: Schichthärte
Für System A1 und Vergleichssystem A(a) wurde nach 20 Stunden Lagerung die Schichthärte bei einer Bandgeschwindigkeit von 5 m/min bestimmt (Pendelhärte nach König, DIN 53157)

| | |
|---|---|
| A1 | 97 Sekunden |
| A(a) | 67 Sekunden |

Das System, in das der Fotoinitiator in Form der erfindungsgemäßen wäßrigen Dispersion eingearbeitet worden ist, zeigt eine deutlich höhere Schichthärte.

## Patentansprüche

1. Wäßrige Fotoinitiator-Dispersionen zur Einarbeitung in wäßrige Dispersionen strahlungshärtbarer Bindemittelsysteme, enthaltend 10 bis 50 Gew. %, bezogen auf die Gesamtmenge, an Fotoinitiator und 5 bis 50 Gew. %, bezogen auf den Gehalt an Fotoinitiator, an nichtionogenen Tensiden mit einem resultierenden HLB-Wert zwischen 8 und 18.

2. Fotoinitiator-Dispersionen nach Anspruch 1, dadurch gekennzeichnet, daß sie 25 bis 45 Gew. % an Fotoinitiator enthalten.

3. Fotoinitiator-Dispersionen nach Anspruch 1 oder 2, dadurch gekennzeichnet, daß sie Gemische von zwei oder mehreren Fotoinitiatoren, gegebenenfalls zusammen mit üblichen Cosensibilisatoren enthalten.

4. Fotoinitiator-Dispersionen nach mindestens einem der Ansprüche 1 bis 3, dadurch gekennzeichnet, daß sie 10 bis 30 Gew. %, bezogen auf den Gehalt an Fotoinitiator, an nichtionogenen Tensiden enthalten.

5. Fotoinitiator-Dispersionen nach mindestens einem der Ansprüche 1 bis 4, dadurch gekennzeichnet, daß sie nichtionogene Tenside mit einem resultierenden HLB-Wert zwischen 10 und 16 enthalten.

6. Fotoinitiator-Dispersionen nach mindestens einem der Ansprüche 1 bis 5, dadurch gekennzeichnet, daß sie als nichtionogene Tenside Gemische aus Polyglycoletherderivaten von Fettalkoholen und Fettalkohol-Fettsäureestern enthalten.

7. Fotoinitiator-Dispersionen nach Anspruch 6, dadurch gekennzeichnet, daß die den nichtionogenen Tensiden zugrundeliegenden Fettalkohole Stearylalkohol und Cetylalkohol und die zugrundeliegenden Fettalkohol-Fettsäureester Fettalkoholstearate und Fettalkoholpalmitate sind.

8. Verfahren zur Herstellung von Fotoinitiatoren enthaltenden wäßrigen Dispersionen strahlungshärtbarer Bindemittelsysteme, dadurch gekennzeichnet, daß die Fotoinitiatoren in Form einer wäßrigen Dispersion nach einem der Ansprüche 1 bis 7 eingearbeitet werden.

## Claims

1. Aqueous photoinitiator dispersions for incorporation into aqueous dispersions of radiation-curable binder systems, containing 10 to 50 % by weight, based on the total amount, of a photoinitiator, and 5 to 50 % by weight, based on the content of photoinitiator, of non-ionogenic surfactants with a resultant HLB value between 8 and 18.

2. Photoinitiator diapersions according to claim 1, characterized in that they contain 25 to 45 % by weight of photoinitiator.

3. Photoinitiator dispersions according to claim 1 or 2, characterized in that they contain mixtures of two or more photoinitiators, optionally together with customary cosensitizers.

4. Photoinitiator dispersions according to at least one of claims 1 to 3, characterized in that they contain 10 to 30 % by weight, based on the content of photoinitiator, of non-ionogenic surfactants.

5. Photoinitiator dispersions according to at least one of claims 1 to 4, characterized in that they contain non-ionogenic surfactants with a resultant HLB value between 10 and 16.

6. Photoinitiator dispersions according to at least one of claims 1 to 5, characterized in that they contain, as non-ionogenic surfactants, mixtures of polyglycol ether derivatives of fatty alcohols and fatty alcohol fatty acid eaters.

7. Photoinitiator dispersions according to claim 6, characterized in that the fatty alcohols on which the non-ionogenic surfactants are based are stearyl alcohol and cetyl alcohol, and the basic fatty alcohol fatty acid eaters are fatty alcohol stearates and fatty alcohol palmitates.

8. Process for the preparation of photoinitiators containing aqueous dispersions of radiation-curable binder systems, characterized in that the photoinitiators are incorporated in the form of an aqueous dispersion according to one of claims 1 to 7.

## Revendications

1. Dispersions aqueuses de photo-amorceurs pour l'incorporation dans des dispersions aqueuses de systèmes de liants durcissables par rayonnement, contenant de 10 à 50 % en poids, par rapport à la quantité totale, de photo-amorceur et de 5 à 50 % en poids, par rapport à la teneur en photo-amorceur, d'agents tensio-actifs non ionogènes ayant une valeur finale du HLB (rapport hydro-lipophile) comprise entre 8 et 18.

2. Dispersions de photo-amorceurs selon la revendication 1, caractérisées en ce qu'elles contiennent de 25 à 45 % en poids en photo-amorceur.

3. Dispersions de photo-amorceurs selon les revendications 1 ou 2, caractérisées en ce qu'elles contiennent des mélanges de deux ou plusieurs photo-amorceurs, éventuellement ensemble avec des co-sensibilisants usuels.

4. Dispersions de photo-amorceurs selon au moins l'une des revendications 1 à 3, caractérisées en ce qu'elles contiennent de 10 à 30 % en poids, par rapport à la teneur en photo-amorceurs, d'agents tensio-actifs non ionogènes.

5. Dispersions de photo-amorceurs selon au moins l'une des revendications 1 à 4, caractérisées en ce qu'elles contiennent des agents tensio-actifs non ionogènes ayant une valeur finale du HLB comprise entre 10 et 16.

6. Dispersions de photo-amorceurs selon au moins l'une des revendications 1 à 5, caractérisées en ce qu'elles contiennent en tant qu'agents tensio-actifs non ionogènes des mélanges de dérivés d'éthers de polyglycols d'alcools gras et d'esters d'acides gras-alcools gras.

7. Dispersions de photo-amorceurs selon la revendication 6, caractérisées en ce que les alcools gras qui sont à la base des agents tensioactifs non ionogènes sont les alcool stéarylique et alcool cétylique et les esters d'acides gras-alcools gras qui forment la base sont les stéarates d'alcools gras et les palmitates d'alcools gras.

8. Procédé pour la préparation de dispersions aqueuses de systèmes de liants durcissables par rayonnement contenant des photo-amorceurs, caractérisé en ce qu'on incorpore les photo-amorceurs sous forme d'une dispersion aqueuse selon l'une des revendications 1 à 7.
